# EUROPEAN PATENT SPECIFICATION

(11) **EP 2 715 766 B1**
(45) Date of publication and mention of the grant of the patent: **26.10.2016**
(21) Application number: 12726603.9
(22) Date of filing: 25.05.2012
(51) Int. Cl.: H01J 37/22, H01J 37/26, G01N 23/02

(54) **METHODS AND SYSTEMS FOR MATERIAL CHARACTERIZATION**
VERFAHREN UND SYSTEME ZUR STOFFCHARAKTERISIERUNG
PROCÉDÉS ET SYSTÈMES DE CARACTÉRISATION D'UN MATÉRIAU

(30) Priority: 27.05.2011 GB 201109014
(43) Date of publication of application: 09.04.2014
(73) Proprietor: Universiteit Antwerpen, 2000 Antwerpen (BE); National Tsing Hua University, Hsinchu 30013 (TW)
(72) Inventor: VAN DYCK, Dirk, B-2630 Aartselaar (BE); CHEN, Fu-Rong, Hsin-Chu 300, Taiwan (TW)
(74) Representative: Wauters, Davy Erik Angelo
(86) International application number: PCT/EP2012/059914
(87) International publication number: WO 2012/163860

(56) References cited:
- US-A1- 2010 032 565
- L.J. ALLEN ET AL: "Structure determination at the atomic level from dynamical electron diffraction data under systematic row conditions", ULTRAMICROSCOPY, vol. 88, no. 3, 1 August 2001 (2001-08-01) , pages 195-209, XP55036615, ISSN: 0304-3991, DOI: 10.1016/S0304-3991(01)00073-0
- FROST B G ET AL: "Two-dimensional dopant profiling of ultrashallow junction with off-axis electron holography: A round robin experiment", JOURNAL OF VACUUM SCIENCE & TECHNOLOGY B: MICROELECTRONICSPROCESSING AND PHENOMENA, AMERICAN VACUUM SOCIETY, NEW YORK, NY, US, vol. 22, no. 1, 1 January 2004 (2004-01-01), pages 427-431, XP012074269, ISSN: 0734-211X, DOI: 10.1116/1.1642648
- TCH M J H ET AL: "Dark-field electron holography for the measurement of geometric phase", ULTRAMICROSCOPY, ELSEVIER, AMSTERDAM, NL, vol. 111, no. 8, 24 April 2011 (2011-04-24), pages 1328-1337, XP028268511, ISSN: 0304-3991, DOI: 10.1016/J.ULTRAMIC.2011.04.008 [retrieved on 2011-04-30]
- GAMM B ET AL: "Object wave reconstruction by phase-plate transmission electron microscopy", ULTRAMICROSCOPY, ELSEVIER, AMSTERDAM, NL, vol. 110, no. 7, 1 June 2010 (2010-06-01), pages 807-814, XP027112526, ISSN: 0304-3991 [retrieved on 2010-02-12]
- L.J. ALLEN ET AL: "Phase retrieval and aberration correction in the presence of vortices in high-resolution transmission electron microscopy", ULTRAMICROSCOPY, vol. 88, no. 2, 1 July 2001 (2001-07-01), pages 85-97, XP55036626, ISSN: 0304-3991, DOI: 10.1016/S0304-3991(01)00072-9
- LICHTE ET AL: "Performance limits of electron holography", ULTRAMICROSCOPY, ELSEVIER, AMSTERDAM, NL, vol. 108, no. 3, 22 October 2007 (2007-10-22), pages 256-262, XP022434068, ISSN: 0304-3991, DOI: 10.1016/J.ULTRAMIC.2007.06.006

## Description

### Field of the invention

The invention relates to the field of material characterization. More particularly, the present invention relates to methods and systems for obtaining information regarding a physical object, e.g. for obtaining tomographic depth information of a sample in an efficient manner.

### Background of the invention

Advanced electron microscopy involves imaging with resolutions at the Angstrom level, and advanced diffraction methods for determining local structure, local composition and electronic information of materials.

The focus variation method for image reconstruction in high-resolution transmission electron microscopy (HRTEM) has been widely used as a method for the reconstruction of the complex-valued electron wave function at the exit plane of a sample object from a series of transmission electron microscopy (TEM) images obtained at different focal distances. This allows, for example, the reconstruction of a phase image of the wave function in the plane of a graphene layer from experimental EM images. A resolution of 0.5 Angstrom can be achieved with this technique and state-of-the-art TEM technology, which enables the visualization of individual carbon atoms in the graphene layer. Although this method offers important advantages in terms of the reconstruction of the magnitude and phase of an electron wave, i.e. a complex-valued reconstruction based on real-space measurements, it is essentially a two-dimensional reconstruction technique.

TEM allows to detect and to visualize individual atoms, but standard techniques only provide a projected image which may be misleading in some cases. In order to obtain depth information, i.e. information regarding the distance of individual atoms relative a reference imaging plane, imaging along at least three different directions is required. For periodic structures, e.g. bulk material with crystalline structure, such projections along at least three axes may suffice to obtain a three-dimensional representation of the periodic structure. In general however, for example for aperiodic materials, tomography techniques can be used to obtain three-dimensional visualization. In tomography, a large number of images are obtained by passing an electron beam through the sample at different rotation angles around the center of the sample, typically by tilting the sample, e.g. over angles from -80° to 80°. For high resolution TEM applications, the phase-contrast dominates image intensities, therefore the image intensity cannot be considered a monotonic function of object thickness. This may complicate the distinction between lower and higher density inclusions and thus the interpretation of the results. Furthermore, the weak phase object approximation used in these methods require a sufficiently thin object, i.e. a sufficiently short electron path length through the object for all projections, therefore limiting the useable range of rotation around a thin-slice object. This may complicate the tomographic reconstruction, e.g. by limiting resolution.

L.J. ALLEN ET AL: "Structure determination at the atomic level from dynamical electron diffraction data under systematic row conditions", ULTRAMICROSCOPY, vol. 88, no. 3, 1 August 2001 (2001-08-01), pages 195-209, XP055036615, ISSN: 0304-3991, DOI: 10.1016/S0304-3991(01)00073-0 discloses phase retrieval and the correction of images for aberrations, in particular defocus and spherical aberration, in high-resolution transmission electron microscopy.

### Summary of the invention

It is an object of the present invention to provide efficient systems and methods for material characterization. It is an advantage of embodiments according to the present invention that the methods and systems for obtaining information provide a plurality of new applications, such as determination of atomic structure, local composition and local electronic structure of new materials, particularly nano-materials, semiconductors, e.g. the amorphous dielectrics in FET electronics, superconductors, alloys, polymer catalysts, ceramics, small particles, surface layers, multi-layers, composites and proteins. It is an advantage of embodiments according to the present invention that the methods and systems for obtaining information can be used for proteins, even if the protein structure is damaged. For example, it is sufficient that e.g. 10% of the atoms are on their original position, in order to use a method according to an embodiment of the present invention for aligning the reconstructed proteins and determining the position of each of the atoms.

It is an advantage of embodiments according to the present invention that 3-dimensional reconstruction using stereography can be improved.

It is an advantage of embodiments according to the present invention that the thickness of extremely thin specimens, e.g. graphene layers or multi-layers, can be determined, for example a thickness in individual single-atom layers can be determined.

It is an advantage of embodiments according to the present invention that taking into account the propagation behavior of waves with different Fourier components, probing of the geometry of the exit surface and of the mass at atomic scale, can be performed.

The above objective is accomplished by a method and device according to the present invention.

A method for determining information regarding an object comprising particles according to independent claim 1 is provided.

It is an advantage of embodiments according to the present invention that based on a wave function representative of an object, a plurality of information can be obtained by performing analysis of at least two spatial frequencies of the detected wave function.

The relation addressed in claim 1 may be a linear relation between the square of the spatial frequency and the phase for different spatial frequencies.

In some embodiments, e.g. when considering thin objects, besides determining the phase also amplitude may be determined for obtaining information regarding the object, e.g. regarding the atoms involved.

The method may comprise deriving an image representation and/or a volumetric image representation of the object.

Analyzing a functional relationship between the spatial frequency and the phase may comprise taking into account a multiplication of a spatial frequency magnitude squared, **g²**, the mathematical constant **π** and a wavelength, **λ**.

The present invention further relates to a system for determining information regarding an object according to independent claim 5. analysis means may be adapted for calculating a slope of a linear relation between the square of the spatial frequency and the phase for different spatial frequencies. The analysis means may be adapted for extrapolating the phase to a spatial frequency equal to zero by means of a linear relation between the square of the spatial frequency and the phase for different spatial frequencies. The analysis means also may be adapted for determining amplitude for obtaining information regarding the object, e.g. regarding the atoms involved.

The present invention also relates to a computer program product for, when executing on a computing device, carrying out a method as described above.

The present invention also relates to a data carrier comprising a computer program product as described above and to the transmission of such a computer program product over a local or wide area network.

The invention is set out in the accompanying independent and dependent claims.

### Brief description of the drawings

FIG. 1 illustrates an exemplary method according to an embodiment of the first aspect of the present invention.
FIG. 2 illustrates a system embodiment according to an embodiment of the second aspect of the present invention.
FIG. 3 illustrates the propagation of waves upon interaction with an object.
FIG. 4 illustrates an exemplary method step for deriving spatial frequencies of a detected wave function and phase values associated with said spatial frequencies, as can be used in embodiments of the present invention.
FIG. 5 illustrates an optional step for correcting phase values obtained by methods according to embodiments of the present invention.
FIG. 6 illustrates an analogy of propagation effects of waves used by embodiments of the present invention with well-known propagation effects in astronomy.
FIG. 7 and FIG. 8 illustrates a relationship between a phase and a phase speed, in comparison with a corresponding relation in physical cosmology and a relationship between the phase speed and the phase, as can be used in embodiments of the present invention.
FIG. 9A to FIG. 12 illustrate different intermediate results of an exemplary method for determining object properties of a graphene object, according to an embodiment of the present invention.
FIG. 13 and FIG. 14 illustrate the possibility for determining a tilt angle of a surface of atoms as can be performed using a method according to an embodiment of the present invention.
FIG. 15 and FIG. 16 illustrate the effect of smearing due to thermal vibration, which may occur using a method according to an embodiment of the present invention.
FIG. 17 to FIG. 19 illustrates the possibility for detecting two sub-lattices in a graphene object, using a method according to an embodiment of the present invention.

The drawings are only schematic and are non-limiting. In the drawings, the size of some of the elements may be exaggerated and not drawn on scale for illustrative purposes.

Any reference signs in the claims shall not be construed as limiting the scope.

In the different drawings, the same reference signs refer to the same or analogous elements.

### Detailed description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

In the description provided herein, numerous specific details are set forth. However, it is understood that embodiments of the invention may be practiced without these specific details. In other instances, well-known methods, structures and techniques have not been shown in detail in order not to obscure an understanding of this description.

By way of illustration, some features and concepts will be compared and explained based on similarities with astrophysical concepts. It is to be understood that aspects and embodiments of the present invention are not limited thereby and that the comparison is only made for ease of understanding.

Where in embodiments of the present invention reference is made to "Hubble plots", reference is made to a graph of phase speed values corresponding to a spatial frequency magnitude as function of phases corresponding to said spatial frequency magnitudes.

Were in embodiments of the present invention reference is made to a phase speed, reference is made to a multiplication of a spatial frequency magnitude squared, **g²**, the mathematical constant **π** and a wavelength, **λ**.

The present invention relates to methods and systems for obtaining information regarding an object comprising particles.

The object may for example be a material specimen, e.g. a graphene layer, a protein or a dielectric for use in an electronic component, such as a field effect transistor (FET). The particles advantageously are objects that can be regarding as point objects such as for example atoms. The particles advantageously may be of atomsize. The particles may have a size in the order of Angström.

In a first aspect, the present invention relates to a method for obtaining information regarding an object. The method is especially suitable for obtaining three-dimensional spatial information regarding objects comprising particles that can be considered point objects.

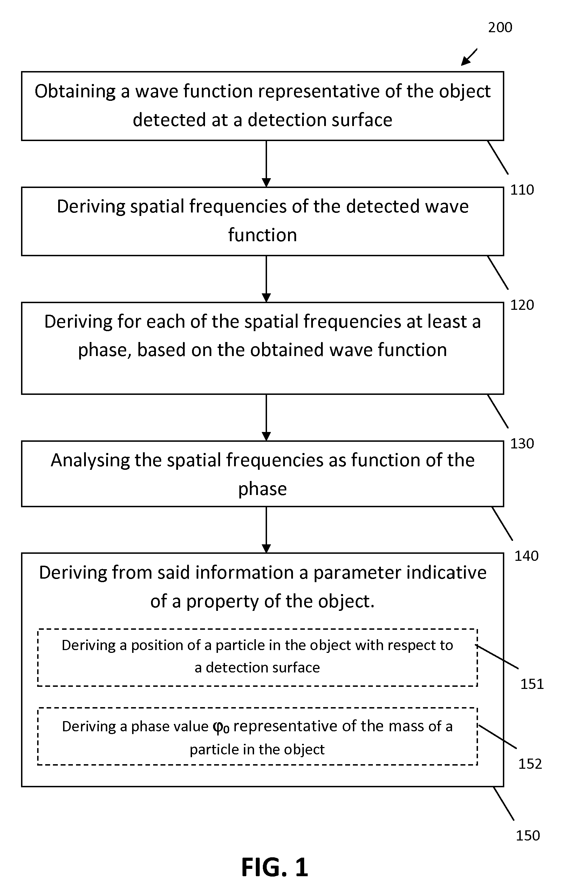

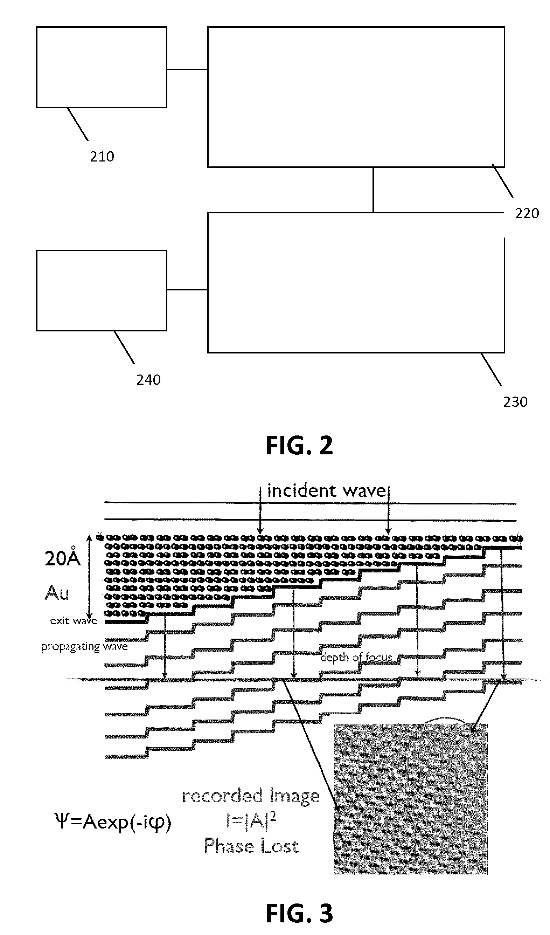

The method 100 is shown in FIG. 1 and will be described in more detail below. The method 100, as illustrated in FIG. 1, for obtaining information regarding an object comprises obtaining 110 an electron wave function representative of an electron beam interacting with the object detected at a detection surface of a detection system for detecting the wave function. Such a wave function may for example be a numerical array of values related to an incident electron beam obtained by processing measurements obtained from an physical array of detective elements on a detector surface, the incident electron beam having interacted with the object while traveling from an electron beam generator through a guidance system, i.e. a detector surface, electron beam generator and guidance system as commonly implemented in a transmission electron microscopy (TEM) apparatus. Such a wave function may typically be composed of phase and amplitude estimates of a wave at discrete locations, i.e. a complex-valued numerical representation of a wave, for instance said electron wave, in points situated in the detection plane. FIG. 3 illustrates how amplitude information of an exit wave can be determined for an incident wave interacting with an object and generating an exit wave that propagates and that is detected using a detection surface. The amplitude can be easily obtained from the recorded image, as the intensity is equal to the square of the amplitude, but the phase information cannot be directly derived therefrom. While amplitude information is readily detectable by a suitable means for detection, such as a charge-coupled device (CCD), phase information may be derived by, for instance, a focal series method, wherein measurements obtained at different focal distances are combined to approximate the phase component. However, other suitable methods may exist, for instance based on off axis holographic principles.

The exemplary method 100 furthermore comprises deriving 120 at least two spatial frequencies **g** of the detected wave function and deriving 130 for each of said at least two spatial frequencies at least a phase **ϕ** based on the obtained wave function. Said spatial frequencies and phases may for example be obtained by performing a spatial domain to spatial frequency domain transform, e.g. a discrete Fourier transform, or a Fast Fourier Transform (FFT), on the wave function, i.e. the array of numeric values. Advantageously, any method providing the pure spatial frequencies may be used. By spatial frequency **g** the magnitude of a spatial frequency vector is intended.

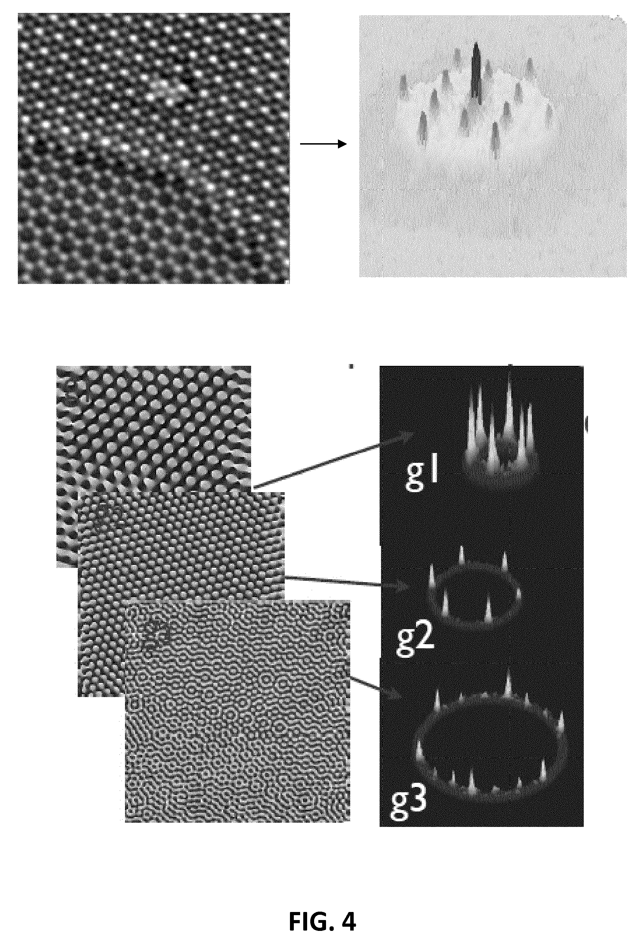

Therefore, for each spatial frequency **g**, a set of complex-valued components can be obtained, i.e. a G-band, each such component associated with a spatial frequency vector having said spatial frequency magnitude **g**. By way of illustration, embodiments of the present invention not being limited thereto, an example of a decomposition of an exit wave into several different spatial frequencies (g) is illustrated in FIG. 4. In the present example, decomposition of a graphene exit wave using a fourier Transform, whereby in the upper part the effect of the Fourier transform of the full exit wave is shown and whereby in the lower part the correspondence between particular spatial frequencies and sub-layers are shown. The derived 130 phase **ϕ** for each spatial frequency **g** may be obtained by calculating the phase, i.e. the argument, of a complex-valued component associated with said spatial frequency **g**, or by applying a aggregating function, e.g. an arithmetic average, to a set of such phases associated with a set of spatial frequency vectors with said spatial frequency magnitude.

Furthermore, a plurality of derived phases **ϕ** for each spatial frequency **g** may be obtained by calculating the phase, i.e. the argument, of a plurality of complex-valued components associated with said spatial frequency **g**.

The method 100 furthermore comprises analyzing 140 the spatial frequency as function of the phase and deriving 150 therefrom at least one parameter indicative of a property of the object. In embodiments according to the present invention, such a property of the object comprises at least either a distance 141 of a particle in the object to the detection surface of the detection system used for detecting the wave function of the object, or a phase value (ϕ₀) 142, the phase value being representative of the mass of a particle in the object. In some embodiments, also amplitude may be used for obtaining information regarding the particles involved.

In some embodiments of the present invention, analyzing 140 the relation between spatial frequency and phase may involve the application of a model, for example a linear regression model, wherein the model assumes a linear relation, e.g. **ϕ**-**ϕ**₀ = π**λg**²(**f**-**f**₀). The factor π**λg**², wherein **λ** is the wavelength of the wave represented by the wave function, is further referred to as the phase speed, in reference to velocity in an analogous cosmology model elucidated below. In this relation, **f** represents a focal distance and **f**₀ a distance of a particle in the object to the focus. Furthermore, the phase value **ϕ**₀ is considered to be proportional to the mass of said particle. It will be seen that for the present example of a linear regression model of phase speed in function of phase will yield a slope coefficient (i.e. a coefficient equal to 1/(**f**-**f**₀)), a distance of a particle in the object to the detection surface of the detection system used for detecting the wave function of the object could be derived. Said linear regression model furthermore yields an intercept coefficient, (i.e. a coefficient equal to **ϕ**₀) e.g. a linear extrapolation of phase to phase speed equal to zero, i.e. an extrapolation of phase to spatial frequency equal to zero, representative of the mass of a particle in the object. Obviously, slope and intercept coefficients of a linear regression model of phase in function of phase speed allow calculation of the same properties.

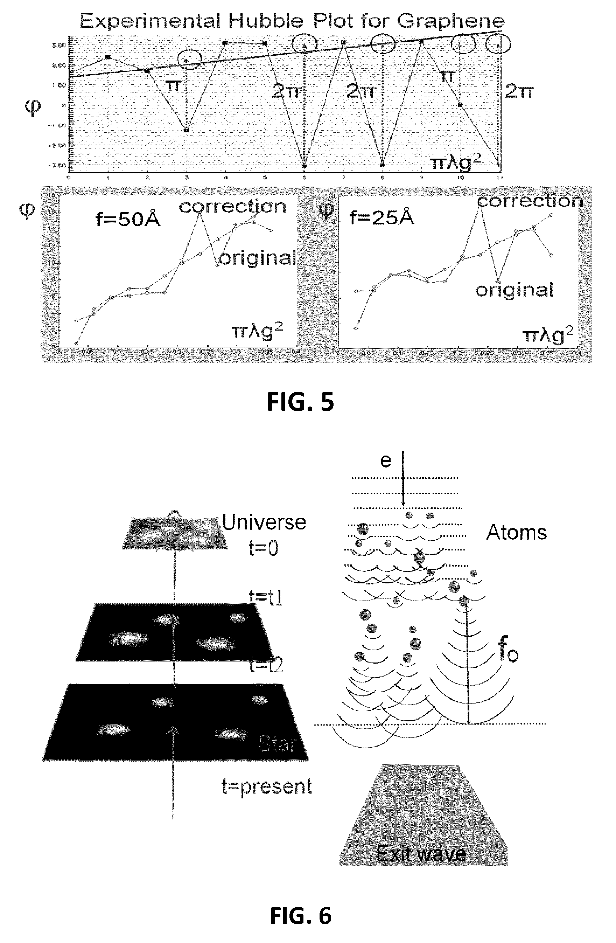

In embodiments of the present invention, analyzing 140 the relation between spatial frequency and phase may furthermore involve a corrective step to adjust phase values by addition or subtraction of integer multiples of π, i.e. when deriving 120 of spatial frequencies and deriving 130 of phases associated with said spatial frequencies is inherently insensitive to phase shifts over multiples of π, e.g. a discrete 2D Fourier analysis. Such a correction is illustrated in FIG. 5. Such a corrective step may for example be incorporated in the analysis 140 of the spatial frequencies in function of the phase, e.g. by iteratively alternating between performing a linear regression fit and adding or subtracting an integer multiple of π to phase values exhibiting a large residual error in the regression model.

Methods according to embodiments of the present invention, may be suitable for implementation in a processing system as hardware or as software, such as in a programmable logic controller or a computer system. In other words, they may be computer implementable.

It is to be noticed that nearly all tomographic methods, such as filtered back projection, SIRT, wave tomography, single particle Cryo, etc. make use of a large number of projections along different directions. Often full rotation of the object is imaged. One technique that can be used when depth information is required for distinguished objects is the use of stereo vision or stereopairs. The method as described in embodiments above, allows viewing all atoms in 2D, in some embodiments with a precision up to 1 picometer and with a depth resolution of 1 Angström. Nevertheless, when a given atom hides an atom in the viewing direction, the hided atom cannot be seen. According to some embodiments of the present invention, the method and system are adapted for viewing under small angle, i.e. up to a few degrees by applying two stereopairs. A system may for example be provided with a controller adapted for controlling viewing under a small angle. Viewing under small angle thus may allow viewing hidden atoms, with the same precision as the non-hidden atoms. It is an advantage of embodiments of the present invention that the big-bang method thus allows viewing all atoms in 3D using only two stereopairs.

The latter also is experimentally advantageous as one of the largest restrictions in electron tomography is the unaccuracy and the inertia of the mechanical tilters. As a tilt of few degress can be obtained by electronically tilting the electron beam, the restrictions occurring in the prior art systems could be overcome, as tilting over small angles is, in combination with the method as described above, sufficient for obtaining detailed information regarding all atoms. Although electronically tilting of the imaging beam may have some effects on the imaging quality, advanced aberration corrections for electron microscopes can compensate at least partially for this.

The method and use of the system are especially advantageous for studying proteins as the procedure for obtaining an image wherein hidden information can be viewed can be shortened as only a small tilting is required which can be performed through electronically tilting. The latter results in the advantage that the imaging time can be small and therefore less radiation damage is introduced.

In a second aspect, the present invention relates to a system for determining information regarding an object. The system 200 is shown in FIG. 2 and will be described in more detail below.

The system 200 comprises an input means 210 for obtaining an electron wave function representative of an electron beam interacting with the object detected at a detection surface of a detection system for detecting the wave function. The input means may comprise an electronic storage device, such as a random-access memory chip, for storing a numerical array of values related to wave measurements, such as electron beam intensity measurements obtained from a physical array of detective elements on a detector surface, e.g. a charge-coupled device (CCD), the electron beam having interacted with, i.e. being diffracted by, the object while traveling from an electron beam generator through a guidance system. The input means may in fact comprise a transmission electron microscopy (TEM) apparatus with a detector surface, an electron beam generator, typically comprising a high-voltage supply and an electron gun, and a beam guidance and collimation system, typically comprising electrostatic and electromagnetic "lenses", or means for receiving detection information from such an apparatus, such as a signal transmission line connection, a radio-frequent communication module and/or a reader for magnetic storage media.

The input means may furthermore comprise a processor for processing data, such as for example a numerical array of values. The processor thus may be adapted for calculating a phase and amplitude representation from beam intensity measurements. The input means may comprise means for transmitting the wave function information to the frequency determination means 220. There typically may be a data communication line from the input means to the frequency determination means 220.

The system 200 also comprises a spatial frequency determination means 220 for deriving from the detected wave function at least two spatial frequencies and for deriving for each of said at least two spatial frequencies at least a phase based on the obtained wave function. Such frequency determination means 220 may comprise a processor, for example a processor executing a Fourier transform on the detected wave function. The frequency determination means may be adapted for receiving said detected wave function from the input means 210 and for transmitting spatial frequency and phase information to the analysis means 230, e.g. by means of electric or optical signal transmission, radio-frequent communication or by interaction with a physical data carrier, such as magnetic data storage media.

Furthermore, the system 200 comprises an analysis means 230 for analyzing the spatial frequency as function of the phase and for deriving therefrom the claimed parameter indicative of a property of the object. Such analysis means may comprise a processor programmed for executing methods as disclosed by embodiments of the present invention. The analysis means may be adapted for receiving spatial frequency and phase information from the means for spatial frequency determination 220.

The analysis means 230 is adapted for deriving at least either a distance of the object to a detection surface of the detection system used for detecting the wave function of the object, or a phase value (*ϕ*₀) being representative of the mass of a particle comprised in the object. For example, the analysis means 230 may comprise a processor for executing a method for calculating a linear regression between the square of spatial frequency and the phase obtained from the spatial frequency determination means 220. The analysis means also may, in addition, be adapted for deriving amplitude which may provide information of the particles involved.

Furthermore, the system 200 comprises an output means 240 for outputting the at least one parameter indicative of a property of the object. The output means 240 may for example comprise a display device, such as a computer monitor, a writing device for storing information on magnetic storage media and/or a printer device. The output means may comprise a processor for transforming the at least one parameter indicative of a property of the object into a suitable presentation. The output provided by the output means 240 may be static in nature, or a dynamic presentation adjustable by means of input from a user. The output means may be adapted for receiving information regarding the at least one parameter indicative of a property of the object from the analysis means 230.

The system 200, or parts thereof, may comprise or consist of a processing system which includes at least one programmable processor coupled to a memory subsystem that includes at least one form of memory, e.g., RAM, ROM, and so forth. A storage subsystem may be included that has at least one disk drive and/or CD-ROM drive and/or DVD drive. In some implementations, a display system, a keyboard, and a pointing device may be included as part of a user interface subsystem to provide for a user to manually input information. Ports for inputting and outputting data also may be included. More elements such as network connections, interfaces to various devices, and so forth, may be included. The various elements of the processing system may be coupled in various ways, including via a bus subsystem.

In a third aspect, the present invention also relates to computer implemented processing systems adapted for performing the different method steps of method embodiments as described above. The different steps may be implemented in a processing system as hardware or as software. Such processing system may for example be comprised in a system according to embodiments of the present invention. The memory of the memory subsystem of such processing system may at some time hold part or all of a set of instructions that when executed on the processing system implement the step(s) of the method embodiments of the present invention. Thus, while a processing system as such is prior art, a system that includes the instructions to implement aspects of the present invention is not prior art. The present invention also includes a computer program product which provides the functionality of any of the methods according to the present invention when executed on a computing device. Further, the present invention includes a data carrier such as for example a CD-ROM, a DVD-ROM or a diskette which stores the computer product in a machine readable form and which executes at least one of the methods of the invention when executed on a computing device. Nowadays, such software is often offered on the Internet or a company Intranet for download, hence the present invention includes transmitting the computer product according to the present invention over a local or wide area network.

Advantages obtained using methods and systems according to embodiments of the present invention can be understood from the following considerations, although embodiments of the presented invention are not to be considered as limited by such theoretical considerations or mathematical formalisms.

The principles of the present invention may be explained by referring to FIG. 6 to FIG. 8. An incident electron wave, e.g. a substantially planar electron wave, interacts with a particle. If said particle is sufficiently small, i.e. may be considered a point object, for example an atom, this results in a substantially spherical wave distortion, i.e. caused by scattering, travelling towards an exit plane, i.e. a detection surface. In the exit plane a planar registration of the wave function is detected. Techniques such as for example exit-wave techniques and phase plate techniques may allow the determination of magnitude and phase of the incident wave. The principles of the present invention involve methods and systems for back-propagation of the detected wave function to the apparent point objects distorting the detected waves, i.e. the atoms.

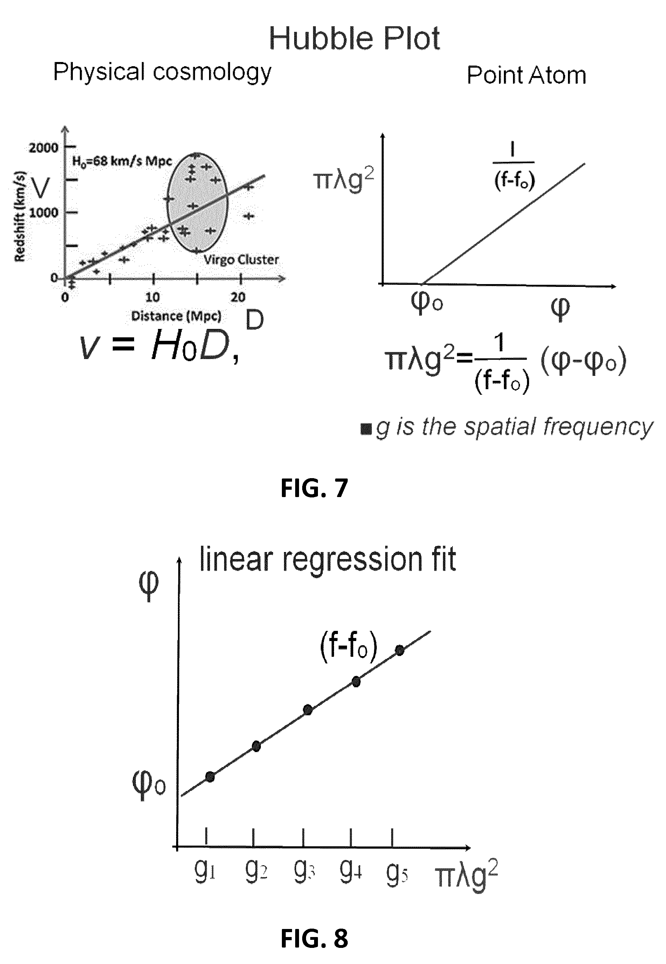

An analogy with the Big-Bang theory may be considered. The Big-Bang concept was developed in response to the observation of Edwin Hubble that the speed of a stellar system **v**, measureable by Doppler shift, is proportional to its distance **D**, i.e. **v** = **H**₀**D**. H₀ thereby is the Hubble's constant. This gave rise to the theory that all such stellar systems are fragments originating from a central explosion site, and allowed to calculate the elapsed time since such an explosion. Similarities between the Big Bang concept and embodiments of the present invention whereby the propagation of waves influenced by atoms is studied, are shown in FIG. 6. In the present invention, a spherical wave, i.e. a spherical wave distortion caused by a point object, is decomposed into different Fourier components, corresponding to spatial frequencies. Every Fourier component has a specific phase related parameter π**λg²**, which could be referred to as the phase speed in analogy with the speed in the Big-Bang theory, proportional to its spatial frequency squared, **g²**, in analogy to measured stellar system speeds in astronomy. The phase of each Fourier component can be measured from the experimentally observed wave function. The phase can be considered as equivalent with the commoving distance to the object. Further analogies can be drawn between time (t) and the focus f. By linear regression of phase in function of phase speed, in analogy with the Hubble equation, a slope and intercept coefficient may be obtained, as illustrated in FIG. 7. The slope allows the determination of the distance **f₀** of the point object, e.g. an atom in an object studied by electron microscopy, to the focus f, while the intercept allows the determination of the null phase ϕ₀, which is proportional to the mass of the atom in the case of electron beam distortion by said atom. This method furthermore allows the determination of other properties, such as atomic structure, the resolution of the microscope, residual aberration of the microscope lenses, etc. In line with the mentioned cosmological analogy, a graph representation, as illustrated in FIG. 8, of phase in function of phase speed according to present invention will be called a "Hubble plot". Alternatively, such information may also be referred to as a graph indicating the phase as function of the phase speed or as a graph indicating the phase as function of a specific phase related parameter π**λg²**. It is to be noticed that embodiments of the present invention are not limited by the mathematical formulation, nor by the cosmological analogy, provided by way of illustration and for ease of explanation only.

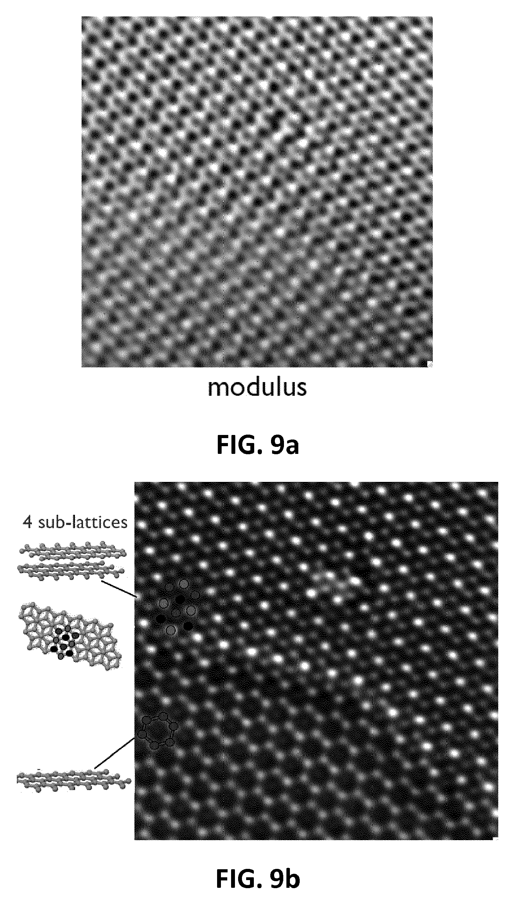

By way of illustration, embodiments of the present invention not being limited thereto, an example of information obtained using a method according to an embodiment of the present invention is further described below with reference to FIG. 9a to FIG. 19.

By way of illustration, embodiments of the present invention not being limited thereto, the method is illustrated for a Buckled Hexagonal Graphene Structure (BHGS). The structure can be observed in a single sheet area. The tilting of the graphene sheet can be determined. It can be seen that the tilting information may be smeared out in a single atom column by thermal vibration.

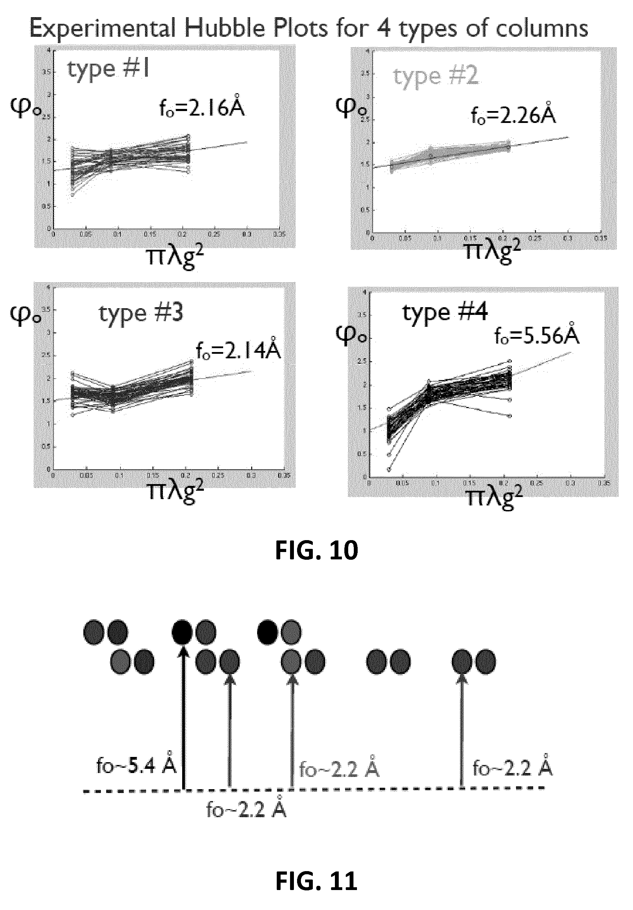

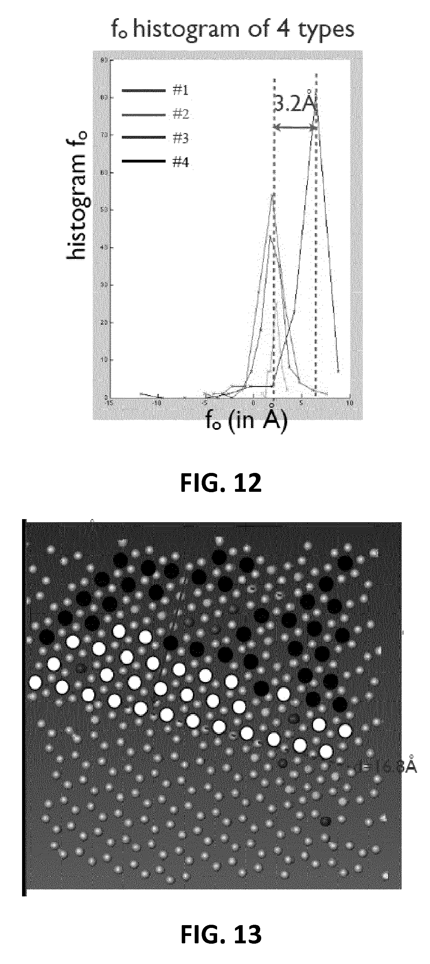

Fig. 9a and FIG. 9b show respectively the modulus and the phase for a graphene object. FIG. 9b shows an image representation of the phase component of the experimentally determined wave function obtained from a graphene object, consisting of four sub-lattices. These sub-lattices comprise in part a single layer and in part of a double layer with a top and bottom layer separated by approximately 3 Angstrom. It is considered advantageous in such cases to determine whether the single layer part is a continuation of the top or of the bottom part of the double layer. FIG. 10 shows a corresponding Hubble plot obtained by a method according to an embodiment of the present invention, wherein the phase is expressed as function of phase speed for four different types of atoms being present in the graphene object, the different types of atoms belonging to different sub-lattices. In FIG. 11 the different types of atoms or atom groups are indicated, each defining a different focal distance f₀. FIG. 12 shows a distance histogram obtained by the discussed linear regression method. The number of counts as function of the distance is illustrated, revealing the four different distances that can be found using the method. This method allows determination of the interlayer distance, i.e. approximately 3.2 Angstrom.

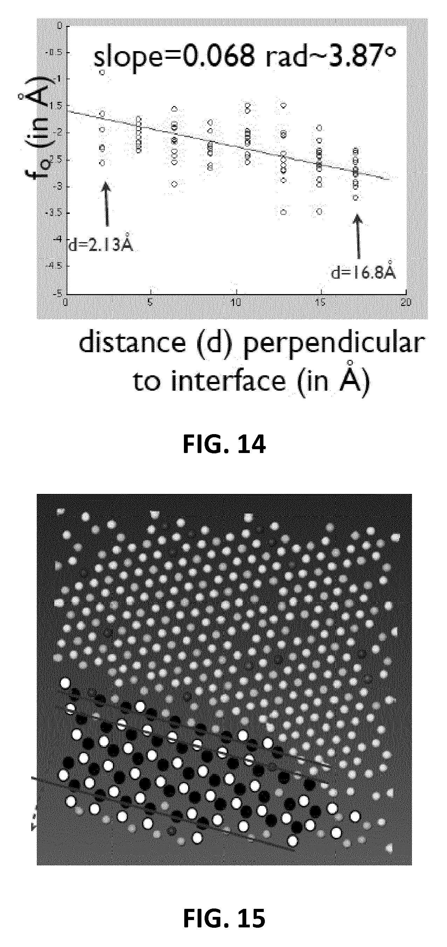

FIG. 13 and FIG. 14 illustrate the possibility for determining tilt of surfaces, by determining the change in distance perpendicular to the interface of the layers as function of the focal distance. FIG. 14 shows the focal distance as function of the distance from the interface, whereby the slope of the curves obtained may result in an estimate of the tilt.

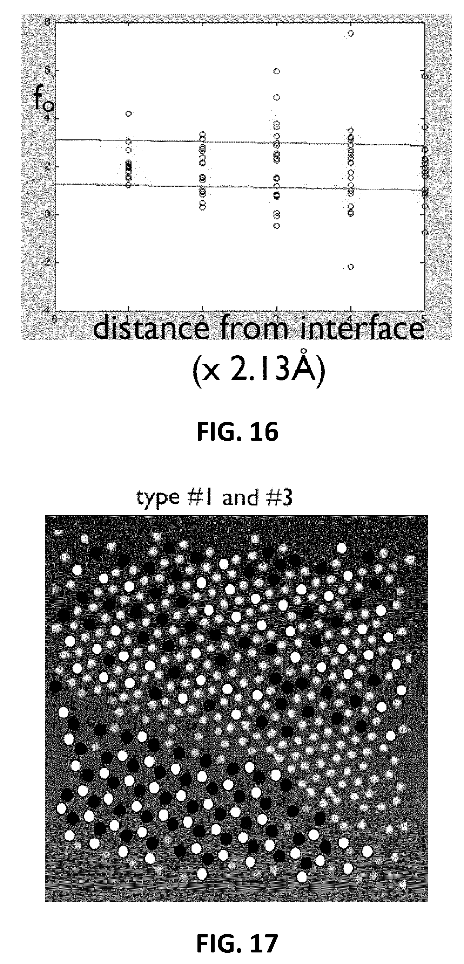

From the experiments, it can be seen that thermal vibration may play an important role. It can be noticed that bi-atoms are bound more strongly which makes the layer stiffer and the thermal displacement smaller. It also can be noticed that two atoms focus better than one. This makes the exit wave more sharply peaked and thus results inbetter depth precision. The columns of type no. 3 are more randomly distributed which is due to the fact that they are more loosely bound and can vibrate thermally more along the vertical axis so that the statistical precision is worse and larger than the systematic effect of the tilt. The tilt effect thus may be smeared out by thermal vibration. An example illustrating this effect is shown in FIG. 15 and FIG. 16.

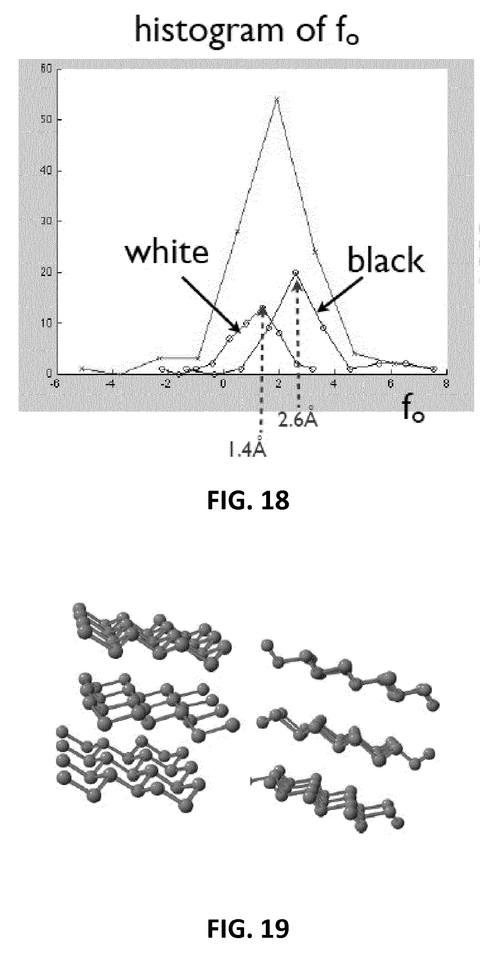

In the present example, a buckled hexagonal sheet can be seen, e.g. in FIG. 17. The unexepected stability of the single graphene sheet is that the two triangles that for an hexagon should be separated slightly which transforms the sp² binding more towards an sp³ binding. For the Buckled Hexagonal Graphene Sheet, a histogram of the focal distance is shown, in the present example being shown in FIG. 18. Two peaks can be fitted to the histogram representative for two sub-lattices being present, as shown in FIG. 19.

## Claims

1. A method (100) for determining information regarding an object comprising particles, the method comprising
- obtaining (110) an electron wave function representative of an electron beam interacting with the object detected at a detection surface of a detection system for detecting the electron wave function,
- deriving (120) at least two spatial frequencies of the detected wave function and deriving (130) for each of said at least two spatial frequencies at least a phase based on the detected electron wave function, and
- analyzing (140) a functional relationship,
**characterized in that** said analyzing is analysing
by taking into account the slope of a relation between the square of the spatial frequency and the phase for different spatial frequencies and deriving (150) therefrom a distance of a particle comprised in the object to a detection surface of the detection system used for detecting the electron wave function representative of the object and/or
by taking into account an extrapolation of the phase to a spatial frequency equal to zero by means of a relation between the square of the spatial frequency and the phase for different spatial frequencies and deriving therefrom a phase value (*ϕ*₀) representative of the mass of a particle of the object.

2. A method (100) according to the previous claim, wherein the method comprises deriving an image representation and/or a volumetric image representation of the object.

3. A method (100) according to any of the previous claims, wherein analyzing a functional relationship between the spatial frequency and the phase comprises taking into account a multiplication of a spatial frequency magnitude squared, **g²**, the mathematical constant **π** and the wavelength, **λ** of the wave represented by the wave function.

4. A method according to any of the previous claims, wherein obtaining (110) a wave function representative of the object comprises obtaining two wave functions representative of the object imaged under different angles by electronically tilting the imaging electron beam.

5. A system (200) for determining information regarding an object comprising particles, the system (200) comprising
- an input means (210) for obtaining an electron wave function representative of an electron beam interacting with the object detected at a detection surface of a detection system for detecting the electron wave function,
- a spatial frequency determination means (220) for deriving from the detected electron wave function at least two spatial frequencies and for deriving for each of said at least two spatial frequencies at least a phase based on the detected electron wave function,
- an analysis means (230) for analyzing a functional relationship,
**characterized in that**
said analysis means is adapted for analyzing
by taking into account the slope of a relation between the square of the spatial frequency and the phase for different spatial frequencies and deriving (150) therefrom a distance of a particle comprised in the object to a detection surface of the detection system used for detecting the wave function representative of the object and/or
- by taking into account an extrapolation of the phase to a spatial frequency equal to zero by means of a relation between the square of the spatial frequency and the phase for different spatial frequencies and deriving therefrom a phase value (*ϕ*₀) representative of the mass of a particle of the object,
- an output means (240) for outputting the distance and/or the phase value of the object.

6. A computer program product for, when executing on a computing device, carrying out a method according to any of claims 1 to 4.

7. A data carrier comprising a computer program product according to claim 6.

8. Transmission of a computer program product according to claim 6 over a local or wide area network.

## Patentansprüche

1. Verfahren (100) zum Bestimmen von Information in Bezug auf ein Partikel umfassendes Objekt, wobei das Verfahren folgendes umfasst
- Erhalten (110) einer Elektronenwellenfunktion, repräsentativ für einen Elektronenstrahl, mit dem Objekt interagierend, das auf einer Detektorfläche eines Detektionssystems detektiert wird, zum Detektieren der Elektronenwellenfunktion,
- Ableiten (120) von zumindest zwei räumlichen Frequenzen der detektierten Wellenfunktion und Ableiten (130) für jede der besagten zumindest zwei räumlichen Frequenzen zumindest einer Phase basierend auf der detektierten Elektronenwellenfunktion, und
- Analysieren (140) einer funktionalen Beziehung,
**dadurch gekennzeichnet, dass** beim besagten Analysieren analysiert wird,
indem man das Gefälle einer Beziehung zwischen der Quadratzahl der räumlichen Frequenz und der Phase für verschiedene räumliche Frequenzen berücksichtigt und daraus einen Abstand eines im Objekt enthaltenen Partikels auf eine Detektorfläche des Detektionssystems ableitet (150), welches zum Detektieren der Elektronenwellenfunktion verwendet wird, die repräsentativ für das Objekt ist,
und/ oder
indem man eine Extrapolation der Phase in eine räumliche Frequenz gleich Null durch eine Beziehung zwischen der Quadratzahl der räumlichen Frequenz und der Phase für verschiedene räumliche Frequenzen berücksichtigt und daraus einen Phasenwert (ϕ₀) ableitet, der repräsentativ für die Masse eines Partikels des Objekts ist.

2. Verfahren (100) nach dem vorherigen Anspruch, wobei das Verfahren das Ableiten einer Bilddarstellung und/ oder einer volumetrischen Bilddarstellung des Objekts umfasst.

3. Verfahren (100) nach irgendeinem der vorherigen Ansprüche, wobei das Analysieren einer funktionalen Beziehung zwischen der räumlichen Frequenz und der Phase die Berücksichtigung einer Multiplikation einer räumlichen Frequenzgröße zum Quadrat, g², der mathematischen Konstanten π und der Wellenlänge λ der Welle umfasst, die durch die Wellenfunktion repräsentiert wird.

4. Verfahren nach irgendeinem der vorherigen Ansprüche, wobei der Erhalt (110) einer für das Objekt repräsentativen Wellenfunktion den Erhalt von zwei für das Objekt repräsentativen Wellenfunktionen umfasst, die in unterschiedlichen Winkeln durch das elektronische Kippen des Bildgebungselektronenstrahls abgebildet werden.

5. System (200) zum Bestimmen von Information in Bezug auf ein Partikel umfassendes Objekt, wobei das System (200) folgendes umfasst
- Eingangsmittel (210) für den Erhalt einer Elektronenwellenfunktion, repräsentativ für einen Elektronenstrahl, mit dem Objekt interagierend, das auf einer Detektorfläche eines Detektionssystems detektiert wird, zum Detektieren der Elektronenwellenfunktion,
- Mittel zum Bestimmen der räumlichen Frequenz (220), zum Ableiten zumindest zweier räumlicher Frequenzen aus der detektierten Wellenfunktion und Ableiten für jede der besagten zumindest zwei räumlichen Frequenzen zumindest einer Phase basierend auf der detektierten Elektronenwellenfunktion,
- Analysemittel (230) zum Analysieren einer funktionalen Beziehung,
**dadurch gekennzeichnet, dass**
die besagten Analysemittel ausgeführt sind, um zu analysieren,
- indem man das Gefälle einer Beziehung zwischen der Quadratzahl der räumlichen Frequenz und der Phase für verschiedene räumliche Frequenzen berücksichtigt und daraus einen Abstand eines im Objekt enthaltenen Partikels auf eine Detektorfläche des Detektionssystems ableitet (150), welches zum Detektieren der Elektronenwellenfunktion verwendet wird, die repräsentativ für das Objekt ist, und/ oder
- indem man eine Extrapolation der Phase in eine räumliche Frequenz gleich Null durch eine Beziehung zwischen der Quadratzahl der räumlichen Frequenz und der Phase für verschiedene räumliche Frequenzen berücksichtigt und daraus einen Phasenwert (ϕ₀) ableitet, der repräsentativ für die Masse eines Partikels des Objekts ist,
- Ausgangsmittel (240) zum Ausgeben des Abstands und/ oder des Phasenwerts des Objekts.

6. Computerprogrammprodukt zur Durchführung des Verfahrens nach irgendeinem der Ansprüche 1 bis 4, wenn es auf einem Computer ausgeführt wird.

7. Datenträger, ein Computerprogrammprodukt nach Anspruch 6 umfassend.

8. Übertragung eines Computerprogrammprodukts nach Anspruch 6 über ein lokales oder ein Weitverkehrsnetzwerk.

## Revendications

1. Procédé (100) de détermination d'informations concernant un objet comprenant des particules, le procédé comprenant
- l'obtention (110) d'une fonction d'onde électronique représentative d'un faisceau électronique interagissant avec l'objet détecté au niveau d'une surface de détection d'un système de détection permettant de détecter la fonction d'onde électronique,
- la déduction (120) d'au moins deux fréquences spatiales de la fonction d'onde détectée et la déduction (130) pour chacune desdites au moins deux fréquences spatiales d'au moins une phase d'après la fonction d'onde électronique détectée et
- l'analyse (140) d'une relation fonctionnelle,
**caractérisé en ce que** l'analyse est l'analyse en prenant en compte la pente d'une relation entre le carré de la fréquence spatiale et la phase pour des fréquences spatiales différentes et en en déduisant (150) une distance d'une particule comprise dans l'objet à une surface de détection du système de détection utilisé pour détecter la fonction d'onde électronique représentative de l'objet
et/ou
en prenant en compte une extrapolation de la phase à une fréquence spatiale égale à zéro au moyen d'une relation entre le carré de la fréquence spatiale et la phase pour des fréquences spatiales différentes et en en déduisant une valeur de phase (ϕ₀) représentative de la masse d'une particule de l'objet.

2. Procédé (100) selon la revendication précédente, dans lequel le procédé comprend la déduction d'une représentation d'image et/ou d'une représentation d'image volumétrique de l'objet.

3. Procédé (100) selon l'une quelconque des revendications précédentes, dans lequel l'analyse d'une relation fonctionnelle entre la fréquence spatiale et la phase comprend le fait de prendre en compte une multiplication d'une grandeur de fréquence spatiale mise au carré, g², la constante mathématique π et la longueur d'onde λ de l'onde représentée par la fonction d'onde.

4. Procédé selon l'une quelconque des revendications précédentes, dans lequel l'obtention (110) d'une fonction d'onde représentative de l'objet comprend l'obtention de deux fonctions d'onde représentatives de l'objet imagé sous différents angles par inclinaison électronique du faisceau électronique d'imagerie.

5. Système (200) permettant de déterminer des informations concernant un objet comprenant des particules, le système (200) comprenant
- un moyen d'entrée (210) permettant d'obtenir une fonction d'onde électronique représentative d'un faisceau électronique interagissant avec l'objet détecté au niveau d'une surface de détection d'un système de détection permettant de détecter la fonction d'onde électronique,
- un moyen de détermination de fréquence spatiale (220) permettant de déduire de la fonction d'onde électronique détectée au moins deux fréquences spatiales et de déduire pour chacune desdites au moins deux fréquences spatiales au moins une phase d'après la fonction d'onde électronique détectée,
- un moyen d'analyse (230) permettant d'analyser une relation fonctionnelle,
**caractérisé en ce que**
ledit moyen d'analyse est adapté pour analyser
- en prenant en compte la pente d'une relation entre le carré de la fréquence spatiale et la phase pour des fréquences spatiales différentes et en en déduisant (150) une distance d'une particule comprise dans l'objet à une surface de détection du système de détection utilisé pour détecter la fonction d'onde représentative de l'objet et/ou
- en prenant en compte une extrapolation de la phase à une fréquence spatiale égale à zéro au moyen d'une relation entre le carré de la fréquence spatiale et la phase pour des fréquences spatiales différentes et en en déduisant une valeur de phase (**ϕ₀**) représentative de la masse d'une particule de l'objet,
- un moyen de sortie (240) permettant de délivrer en sortie la distance et/ou la valeur de phase de l'objet.

6. Produit de programme d'ordinateur permettant, lorsqu'il s'exécute sur un dispositif informatique, de réaliser un procédé selon l'une quelconque des revendications 1 à 4.

7. Support de données comprenant un produit de programme d'ordinateur selon la revendication 6.

8. Transmission d'un produit de programme d'ordinateur selon la revendication 6 sur un réseau local ou étendu.
